# FASCICULE DE BREVET EUROPEEN

(11) **EP 2 449 584 B1**
(45) Date de publication et mention de la délivrance du brevet: **12.02.2014**
(21) Numéro de dépôt: 10726545.6
(22) Date de dépôt: 01.07.2010
(51) Int. Cl.: H01L 21/768

(54) **PROCEDE DE CREATION D'UNE ZONE CRISTALLINE DE METAL, NOTAMMENT DANS UN CIRCUIT INTEGRE**
VERFAHREN ZUR HERSTELLUNG EINES KRISTALLINEN METALLBEREICHS, IM BESONDEREN BEI EINER INTEGRIERTEN SCHALTUNG
METHOD FOR CREATING A CRYSTALLINE AREA OF METAL, IN PARTICULAR IN AN INTEGRATED CIRCUIT

(30) Priorité: 03.07.2009 FR 0954593
(43) Date de publication de la demande: 09.05.2012
(73) Titulaire: Commissariat à l'Énergie Atomique et aux Énergies Alternatives, 75015 Paris (FR)
(72) Inventeur: CAYRON, Cyril, F-38100 Grenoble (FR); MAITREJEAN, Sylvain, F-38000 Grenoble (FR)
(74) Mandataire: Ilgart, Jean-Christophe
(86) Numéro de dépôt international: PCT/EP2010/059388
(87) Numéro de publication internationale: WO 2011/000923

(56) Documents cités:
- EP-A2- 1 845 554
- US-A1- 2007 238 294
- US-A1- 2009 035 936

## Description

L'invention a trait à un procédé de création d'une zone cristalline de métal, notamment dans un circuit intégré.

La conductivité d'un métal dépend de sa structure cristalline, ce qui explique qu'on s'intéresse à maîtriser la formation de celle-ci dans le cas de lignes d'interconnexion des circuits dont la matière a été déposée dans les tranchées d'un substrat : la formation de lignes monocristallines ou du moins cristalline à gros grains donnerait une conductivité particulièrement bonne, accompagnée d'une baisse de l'échauffement et d'une meilleure transmission de l'électricité, les défauts de transport des électrons étant plus particulièrement concentrés aux joints de grains ; or ces défauts sont de plus en plus manifestes à mesure que des lignes d'interconnexion toujours plus étroites sont demandées.

Le but de l'invention est donc de gouverner la microstructure cristalline d'éléments tels que des lignes d'interconnexion des circuits intégrés pour obtenir une telle structure monocristalline ou à gros grains dans laquelle les joints de grains sont éliminés. Les grains obtenus à la fabrication ont typiquement une taille de l'ordre de 1 à 100 nm, quand la structure métallique n'est pas amorphe. L'invention vise à obtenir une structure cristalline aux grains de l'ordre de 100 fois plus gros, de façon à présenter un seul grain ou un petit nombre de grains sur la longueur des lignes d'interconnexion (1 à 10 µ*m* ou plus). La taille des grains peut être définie comme leur dimension moyenne.

L'état de l'art comprend la connaissance que la structure cristalline d'un milieu métallique continu composé des lignes d'interconnexion établies dans des tranchées d'un substrat et d'une couche supérieure (surépaisseur), qui recouvre les lignes en s'étendant sur toute la surface du substrat et a été réalisée pendant la même étape de dépôt qu'elles , est d'abord modifiée dans cette couche supérieure quand un traitement thermique tel qu'un recuit est entrepris, avant de gagner les lignes sous-jacentes grâce à la continuité du milieu métallique qu'elles forment. Les traitements de recuit sont courants pour accroître la taille des grains dans les lignes à partir des grains très petits obtenus au dépôt. L'article « Cu grain growth in interconnects trenches-Experimental charactérization of the overburden effect », par Carreau et autres (paru dans Microelectronic Engineering n°85 (2008), p.2133-2136), décrit ce phénomène.

Le document US-A-2009/035936 mentionne que l'orientation des grains d'une couche métallique peut être modifiée en déposant sur elle une autre couche ayant l'orientation des grains souhaitée, puis en réalisation un recuit. Cette couche déposée peut avoir des grains plus gros que ceux de la couche qu'elle recouvre, mais aucun effet sur la taille des grains de la couche n'est mentionné.

L'invention concerne un procédé de création d'une zone de métal, comprenant les étapes de:
- réalisation d'au moins une zone en creux dans un substrat,
- dépôt d'un métal dans la zone en creux, et au-dessus, en formant une couche continue de surépaisseur, et présentant une première taille de grains,
- enlèvement total ou partiel de la couche de surépaisseur,
caractérisé par les étapes de :
- polissage d'une surface libre du métal,
- mise en contact d'une surface libre du métal et d'une surface d'un cristal du même métal, présentant une seconde taille de grains supérieure à la première taille, ladite surface du cristal ayant subi un polissage,
- recuit du métal et du cristal en faisant croître la taille des grains dans le métal,
- enlèvement du cristal.

La seconde taille de grains (considérée d'après la dimension moyenne des grains, par exemple) peut être au moins cent fois plus grande que la première, pour exploiter pleinement les avantages de l'invention.

Par rapport à l'art antérieur, les étapes essentielles consistent à retirer la couche de surépaisseur, où la modification de la structure prend naissance d'après la connaissance existante, et la remplacer par un cristal ayant la structure voulue pour tout le métal, fabriqué séparément et raccordé au métal déposé dans les tranchées par apposition au substrat. Les inventeurs ont constaté que la structure cristalline s'imposait alors aussi dans le métal emplissant les tranchées malgré le défaut de continuité cristallographique avec leur métal; il est seulement nécessaire d'établir un contact suffisamment intime entre elles, facilité par le polissage.

Le métal ainsi transformé des lignes peut être choisi parmi le cuivre, l'argent ou l'aluminium ; le substrat peut quant à lui être choisi parmi le silicium, le germanium et le SIC (carbure de silicium).

Le cristal rapporté doit généralement avoir une épaisseur suffisante pour que son influence puisse s'imposer sur toute la profondeur de la ligne. Une valeur de 50nm est préconisée dans certaines conditions usuelles.

La mise en contact intime peut comprendre un pressage mécanique, un collage moléculaire ou une soudure.

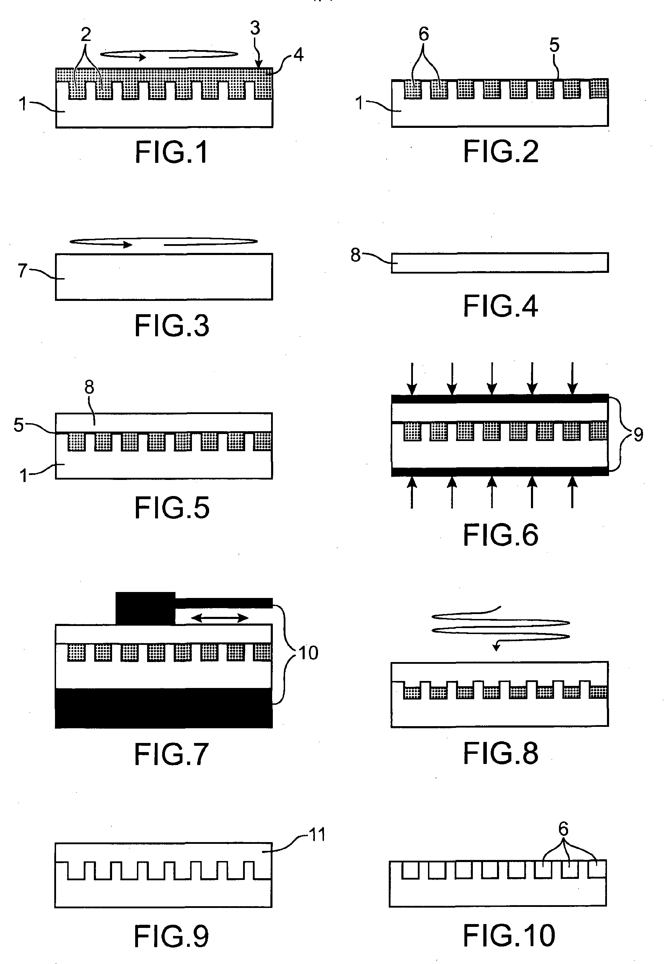

L'invention sera maintenant décrite en liaison aux figures 1 à 10, qui illustrent les étapes successives du procédé.

Un substrat 1 a été creusé de tranchées 2, puis un dépôt 3 de matière métallique a été établi sur le substrat 1, comblant les tranchées et formant aussi une couche de surépaisseur 4 (figure 1). Une étape préliminaire est un polissage qui retire la couche de surépaisseur 4 en tout ou en partie. Le dépôt 3 est souvent électrochimique, mais l'invention fonctionne aussi avec d'autres procédés de dépôt, ainsi qu'avec les dépôts composés où une couche inférieure de barrière et une première couche conductrice sont déposées par un dépôt physique ou chimique en phase de vapeur, ou par électrochimie. Il est toutefois possible de pratiquer l'invention en laissant un reliquat de la surépaisseur afin que subsiste une surface continue libre 5 en le métal (figure 2). Le reliquat a une épaisseur très faible, de moins de 10 nm environ, quand il existe. Le métal dans les tranchées forme des lignes conductrices 6.

Un monocristal 7 de même nature métallique que le dépôt 3 a aussi été préparé (figure 3), et son épaisseur est éventuellement réduite par polissage (figure 4) pour obtenir une couche assez mince pour être appliquée exactement sur la surface libre 5 de l'autre pièce. Ainsi qu'on l'a dit, l'invention serait aussi opérante avec un polycristal aux grains beaucoup plus gros que ceux du dépôt 3. Le monocristal réduit porte la référence 8. Son épaisseur doit toutefois rester suffisante pour induire la recristallisation qu'on va décrire, et aussi pour pouvoir le manipuler commodément. Une épaisseur de 50nm semble par exemple nécessaire pour des lignes de cuivre de 100nm de largeur et de 180nm de hauteur, et des valeurs nettement supérieures de cette épaisseur, de plus de 100nm, voire quelques microns, peuvent être préférées pour une couche de cuivre. Les polissages effectués sur la surépaisseur 4 et le monocristal 7 doivent comporter une très bonne finition, par le procédé CMP (polissage mécano-chimique) ou par une table vibrante ; les surfaces polies sont finalement désoxydées.

L'étape suivante, illustrée à la figure 5, consiste en l'apposition du monocristal 8 sur la surface libre 5 par les surfaces polies et désoxydées. Un contact intime entre les surfaces doit être maintenu. Quoiqu'il soit envisagé qu'un simple collage moléculaire permette de l'obtenir, on envisage de recourir aussi à des procédés plus forts qu'un pressage, comme un soudage par diffusion par une compression uniaxiale à chaud (figure 6), un collage moléculaire ou un soudage par ultrasons (figure 7), en employant des appareils de pressage 9 et de soudage 10 idoines. Le soudage par ultrasons semble particulièrement adapté. L'étape suivante, illustrée à la figure 8, est un recuit de l'assemblage, qui est accompli, selon les dimensions, à une température comprise entre 200°C et 600°C pendant une durée comprise entre une minute et quelques heures, pour des lignes d'interconnexion en cuivre. La température et la durée de recuit seront déterminées de façon empirique selon le matériau à modifier. La pression à exercer dépend aussi de diverses conditions, entre autres du mode d'application : une pression de quelques mégapascals (5MPa ou éventuellement 10MPa par exemple) peut être préconisée par un soudage par pression uniaxiale, de quelques dizaines de mégapascals (30MPa par exemple) pour un soudage par friction, mais elle peut être très faible pour un soudage moléculaire. Le monocristal, d'abord réservé à la couche 8, s'étend peu à peu dans les lignes 6 en se propageant de haut en bas. L'état de la figure 9 est finalement obtenu : tout le métal est devenu monocristallin.

Les étapes de soudure et de recuit peuvent être réalisées simultanément lorsque la température nécessaire à la soudure est suffisamment élevée pour recristalliser le métal.

Une dernière étape est un polissage pour éliminer la couche métallique supérieure 11, continue sur le substrat 1, issue du monocristal 8 et qui forme une nouvelle surépaisseur, et séparer complètement les lignes 6 les unes des autres. Le polissage peut être grossier, puis de plus en plus fin, comme dans les étapes préliminaires du procédé. A la fin du polissage, comme illustré à la figure 10, les lignes sont monocristallines, ont toutes la même orientation, et le circuit est prêt à l'usage ou au dépôt d'autres couches de matière.

## Revendications

1. Procédé de création d'une zone cristalline de métal, comprenant les étapes de:
- réalisation d'au moins une zone en creux (2) dans un substrat (1),
- dépôt d'un métal (6) dans la zone en creux, et au-dessus, en formant une couche continue de surépaisseur (4), et présentant une première taille de grains,
- enlèvement total ou partiel de la couche de surépaisseur (4), **caractérisé par** les étapes de :
- polissage d'une surface libre du métal,
- mise en contact de la surface libre (5) du métal et d'une surface d'un cristal (8) du même métal, présentant une seconde taille de grains supérieure à la première taille, ladite surface du cristal (8) ayant subi un polissage,
- recuit du métal et du cristal en faisant croître la taille des grains dans le métal,
- enlèvement du cristal (11).

2. Procédé selon la revendication 1, **caractérisé en ce que** le métal est choisi parmi le cuivre, l'argent et l'aluminium.

3. Procédé selon la revendication 1 ou 2, **caractérisé en ce que** le substrat est choisi parmi le silicium, le germanium et le carbure de silicium.

4. Procédé selon l'une quelconque des revendications 1 à 3, **caractérisé en ce que** le cristal a une épaisseur d'au moins 50nm.

5. Procédé selon l'une quelconque des revendications 1 à 4, **caractérisé en ce que** la mise en contact comprend un pressage.

6. Procédé selon l'une quelconque des revendications 1 à 4, **caractérisé en ce que** la mise en contact comprend une soudure.

7. Procédé selon la revendication 6, **caractérisé en ce que** la soudure est faite par ultrasons.

8. Procédé selon l'une quelconque des revendications 1 à 4, **caractérisé en ce que** la mise en contact comprend un collage moléculaire.

9. Procédé selon l'une quelconque des revendications 1 à 8, **caractérisé en ce que** la seconde taille de grains est au moins 100 fois plus grande que la première.

## Patentansprüche

1. Verfahren zur Erzeugung eines kristallinen Metallbereichs, umfassend die Schritte:
- Erzeugen zumindest eines vertieften Bereichs (2) auf einem Substrat (1)
- Aufbringen eines Metalls (6) auf den vertieften Bereich, wobei darauf eine kontinuierliche Überzugsschicht (4) gebildet wird, und eine erste Korngröße vorhanden ist,
- vollständiges oder teilweises Entfernen der Überzugsschicht (4), **gekennzeichnet durch** die Schritte:
- Polieren einer freien Metalloberfläche,
- Inkontaktbringen der freien Metalloberfläche (5) und einer Oberfläche eines Kristalls (8) aus dem gleichen Metall, welches eine zweite Korngröße größer als die erste Größe aufweist, wobei die Oberfläche des Kristalls (8) poliert ist,
- Glühen des Metalls und des Kristalls, damit die Korngröße im Metall wächst,
- Entfernen des Kristalls (11).

2. Verfahren nach Anspruch 1, **dadurch gekennzeichnet, dass** das Metall aus Kupfer, Silber und Aluminium ausgewählt wird.

3. Verfahren nach Anspruch 1 oder 2, **dadurch gekennzeichnet, dass** das Substrat aus Silicium, Germanium und Siliciumcarbid ausgewählt wird.

4. Verfahren nach einem der Ansprüche 1 bis 3, **dadurch gekennzeichnet, dass** der Kristall eine Größe von mindestens 50 nm aufweist.

5. Verfahren nach einem der Ansprüche 1 bis 4, **dadurch gekennzeichnet, dass** das Inkontaktbringen ein Pressen umfasst.

6. Verfahren nach einem der Ansprüche 1 bis 4, **dadurch gekennzeichnet, dass** das Inkontaktbringen ein Schweißen umfasst.

7. Verfahren nach Anspruch 6, **dadurch gekennzeichnet, dass** das Schweißen durch Ultraschallschweißen erfolgt.

8. Verfahren nach einem der Ansprüche 1 bis 4, **dadurch gekennzeichnet, dass** das Inkontaktbringen ein molekulares Kleben umfasst.

9. Verfahren nach einem der Ansprüche 1 bis 8, **dadurch gekennzeichnet, dass** die zweite Korngröße mindestens 100-fach größer als die erste ist.

## Claims

1. Method for creating a crystalline metal region, comprising the steps of:
- forming at least one hollowed region (2) in a substrate (1),
- depositing a metal (6) in the hollowed region, and thereupon, forming a continuous build-up layer (4) having a first grain size,
- partially or fully removing the build-up layer (4), **characterized by** the steps of:
- polishing a free surface of the metal,
- contacting the free surface (5) of the metal with a surface of a crystal (8) of the same metal having a second grain size larger than the first size, the surface of the crystal (8) having been subjected to polishing,
- annealing the metal and the crystal,
- removing the crystal (11).

2. The method according to claim 1, **characterized in that** the metal is chosen from among copper, silver and aluminium.

3. The method according to claim 1 or 2, **characterized in that** the substrate is chosen from among silicon, germanium and silicon carbide.

4. The method according to any of claims 1 to 3, **characterized in that** the crystal has a thickness of at least 50 nm.

5. The method according to any of claims 1 to 4, **characterized in that** the contacting comprises pressing.

6. The method according to any of claims 1 to 4, **characterized in that** the contacting comprises bonding.

7. The method according to claim 6, **characterized in that** the bonding is ultrasonic bonding.

8. The method according to any of claims 1 to 4, **characterized in that** the contacting comprises molecular bonding.

9. The method according to any of claims 1 to 8, **characterized in that** the second grain size is at least 100 times larger than the first.
